# FASCICULE DE BREVET EUROPEEN

(11) **EP 0 631 700 B1**
(45) Date de publication et mention de la délivrance du brevet: **09.07.1997**
(21) Numéro de dépôt: 94902561.3
(22) Date de dépôt: 07.01.1994
(51) Int. Cl.: H03K 17/95, G01B 7/14

(54) **PROGRAMMATEUR ROTATIF POUR LA COMMANDE DE FINS DE COURSE**
Drehbare Progammiereinrichtung zur Bestimmung von Endlagen
ROTARY PROGRAMMER FOR TRAVEL-LIMIT CONTROL

(30) Priorité: 20.01.1993 BE 9300054
(43) Date de publication de la demande: 04.01.1995
(73) Titulaire: COCKERILL SAMBRE, B-4100 Seraing (BE)
(72) Inventeur: CITTERS, Christian, B-6120 Nalinnes (BE); CALLARI, Michel, B-6240 Farciennes (BE); LODEWIJCKX, Jozef, B-6040 Jumet (BE)
(74) Mandataire: Vanderperre, Robert
(86) Numéro de dépôt international: BE9400001
(87) Numéro de publication internationale: WO9417594

(56) Documents cités:
- EP-A- 0 134 029
- US-A- 4 922 064
- US-A- 5 219 068

## Description

La présente invention est relative à un dispositif programmateur rotatif destiné à la commande de fins de course dans une installation industrielle.

Il trouve par exemple son application dans les installations de levage, les chaînes de transport, le contrôle de la levée et de l'abaissement des rouleaux enrouleurs des bobineuses dans les laminoirs, le contrôle du serrage entrefer des rouleaux pinceurs de ces enrouleurs et en façon générale dans toute installation ou tout mécanisme où doivent être contrôlées des positions physiques d'un chemin parcouru.

Pour la commande d'interrupteurs électriques dans des installations de ce genre on utilise couramment des programmateurs rotatifs à cames à contacts mécaniques. Un programmateur de ce type est constitué de plusieurs disques porte-cames montés sur un arbre couplé de manière débrayable à un arbre d'entraînement. Chaque disque porte deux cames fixées sur le pourtour du disque en des positions ajustables pour entrer successivement en contact avec un interrupteur électrique pendant la rotation de l'arbre. Les disques à cames sont serrés les uns contre les autres et couplés entre eux. L'ensemble est logé dans un carter en aluminium d'où émerge une extrémité de l'arbre porte-cames, destinée 3 être couplée à l'arbre d'entraînement carré.

Pour ajuster la position angulaire d'une came il est nécessaire de débrayer l'arbre porte-cames, de desserrer les vis de fixation de la came, de faire glisser la came jusque dans la position angulaire voulue, puis de resserrer les vis de fixation et de réembrayer l'arbre porte-cames. Ces manipulations prennent un temps non négligeable.

De plus, dans le cas d'interrupteurs pour la commande des rouleaux enrouleurs dans un laminoir, l'ajustement des cames doit se faire avec l'intervention de deux personnes : l'une effectuant les manipulations au programmateur et l'autre se trouvant au pupitre de commande pour indiquer à la première le moment où l'ajustement est correct car il est impératif que les positions de contact ajustées provoquent les commutations au moment précis voulu. Il faut ensuite faire un essai pour s'assurer que les commutations se produisent correctement dans le temps. Avec ce dispositif connu, le temps nécessaire au réglage est de l'ordre de 20 minutes par came.

Le dispositif connu présente d'autres inconvénients. L'accès aux cames à ajuster est malaisé par suite de leur disposition et de l'environnement qui règne généralement à ces endroits vu la température élevée des produits en cours de laminage et la présence d'eau projetée pour refroidir les engins tels que rouleaux, mandrins, etc. De plus, la présence du liquide de refroidissement et le défaut d'étanchéité du carter occasionnent la rouille des interrupteurs électriques.

L'invention a pour but de proposer un nouveau dispositif programmateur rotatif qui ne présente pas les inconvénients du programmateur rotatif connu.

US-A-4 922 064 décrit un programmateur rotatif qui sert à détecter la position d'une porte. Ce programmateur peut comprendre un détecteur de proximité inductif.

L'objectif de l'invention est atteint grâce à un programmateur rotatif comprenant un arbre sur lequel est monté au moins un support portant au moins un élément ajustable en position angulaire pour déterminer le moment d'une fin de course, lequel programmateur est remarquable en ce que chaque support est constitué d'un tambour portant au moins un segment métallique ajustable en position angulaire sur son pourtour et en ce qu'il comprend au moins un détecteur de proximité inductif disposé dans un plan transversal à l'axe du tambour de manière que sa face active se trouve située à une distance prédéterminée du parcours d'un segment métallique pendant la rotation du tambour, le détecteur de proximité inductif précité produisant un signal lors du passage d'un segment métallique dans son champ de détection.

Un organe indicateur peut être prévu pour répondre au signal du détecteur de proximité inductif.

Selon l'invention, l'arbre porte-tambour se trouve couplé à un arbre d'entraînement au moyen d'un plateau d'embrayage bloqué en position d'embrayage par un verrou de blocage. Celui-ci consiste par exemple en un bras articulé autour d'un pivot de manière à pouvoir pivoter dans un plan transversal à l'arbre porte-tambour.

Le dispositif programmateur selon l'invention est décrit plus en détail dans ce qui suit à l'aide des dessins ci-joints.

La figure 1 est une vue de dessus d'un programmateur selon l'invention.

La figure 2 est une vue en élévation latérale du dispositif de la figure 1.

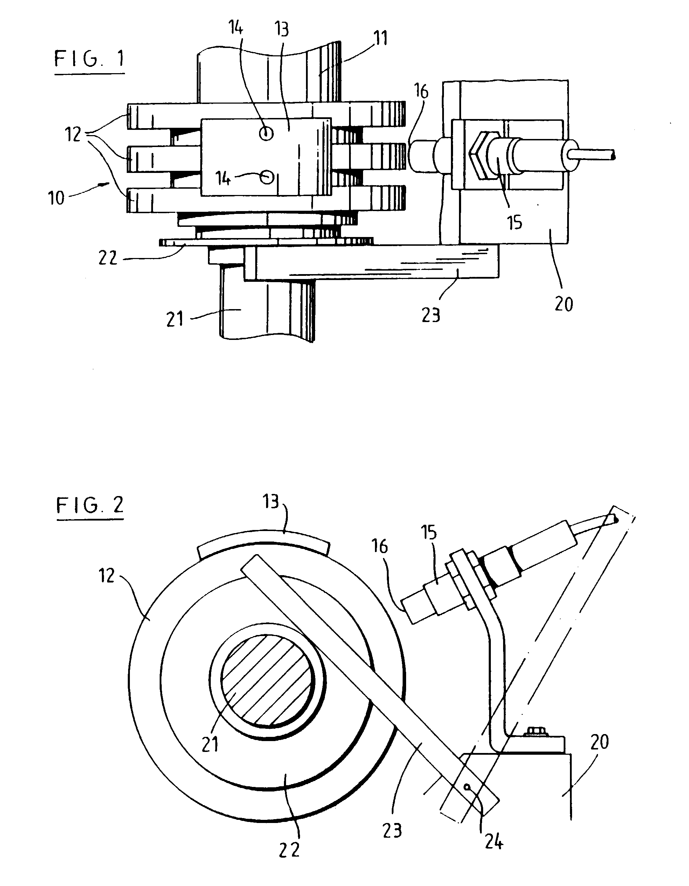

Sur un arbre 11 sont montés un ou plusieurs tambours de support. La figure 1 montre un seul tambour. Le tambour de support 10 consiste ici en plusieurs plateaux gradués 12 le long desquels coulisse au moins un segment métallique 13 en forme de I. Celui-ci peut être fixé dans l'une ou l'autre de plusieurs positions angulaires ajustables au moyen de vis de serrage. Le dessin montre deux vis de serrage 14 du segment mais celui-ci pourrait aussi être fixé au moyen d'une seule vis.

Lors de la rotation de l'arbre 11, le tambour 10 entraîne le segment métallique 13 et celui-ci passe en regard d'un détecteur de proximité inductif 15 disposé dans un plan transversal à l'axe de l'arbre 11. Le détecteur de proximité inductif est un dispositif connu en soi, qui produit un signal de commutation tout ou rien lorsqu'une pièce métallique passe dans le champ magnétique HF rayonné devant la face active du détecteur. Grâce à cette disposition, le détecteur 15 détecte de manière sûre et fiable la présence du segment métallique 13 en regard de sa face active 16. La distance de détection dépend de la taille de l'enroulement générateur du champ magnétique.

L'arbre porte-tambour 11 est avantageusement couplé à un arbre d'entraînement 21 au moyen d'un plateau d'embrayage 22 qui se trouve bloqué en position d'embrayage par un verrou 23 articulé autour d'un pivot 24 solidaire du boîtier 20 de manière à pouvoir pivoter dans un plan transversal à l'axe de l'arbre 11.

L'ajustement angulaire d'un segment métallique 13 peut se faire de manière simple et rapide. Il suffit de dévisser la ou les vis de serrage 14 du segment métallique, de l'amener dans la position voulue et de revisser la ou les vis de serrage 14 sans qu'il soit nécessaire de débrayer l'arbre porte-tambour 11. Cet ajustement demande à peine 5 minutes, d'où un gain de temps appréciable grâce à l'invention. De plus, même le débrayage de l'arbre porte-tambour 11 peut ici se faire en un clin d'oeil.

D'autre part, l'absence de frottement des segments contre des pièces de contact élimine les problèmes d'usure et de rouille qui se rencontrent dans les programmateurs rotatifs à contacts selon la technique antérieure.

Avantageusement, chaque détecteur de proximité inductif se trouve connecté à un dispositif indicateur, par exemple une diode luminescente, agencé pour produire un signal lorsque le détecteur 15 correspondant détecte le passage d'un segment métallique 13 dans son champ de détection.

## Revendications

1. Programmateur rotatif pour la commande de fins de course, comprenant un arbre (11) sur lequel est monté au moins un support portant au moins un élément ajustable en position angulaire pour déterminer le moment d'une fin de course, et un détecteur de proximité inductif (15) produisant un signal lors du passage dudit élément ajustable en position angulaire dans son champ de détection,
caractérisé en ce que le support est constitué d'un tambour (10) portant au moins un segment métallique (13) ajustable en position angulaire sur son pourtour, le tambour (10) est monté sur ledit arbre (11) qui est couplé à un arbre d'entraînement (21) au moyen d'un plateau d'embrayage (22) bloqué en position d'embrayage par un verrou de blocage (23), le détecteur de proximité inductif (15) précité étant disposé dans un plan transversal à l'axe du tambour de manière que sa face active (16) se trouve située à une distance prédéterminée du parcours du segment métallique (13) pendant la rotation du tambour (10).

2. Dispositif selon la revendication 1, caractérisé en ce que le verrou de blocage (23) consiste en un bras articulé autour d'un pivot (24) de manière à pouvoir pivoter dans un plan transvesal à l'arbre porte-tambour.

3. Dispositif selon la revendication 1 ou 2, caractérisé en ce qu'un organe indicateur est prévu pour répondre à un signal du détecteur de proximité inductif.

4. Dispositif selon la revendication 3, caractérisé en ce que l'organe indicateur est une diode luminescente.

## Patentansprüche

1. Drehbarer Programmwähler für die Steuerung von Enden eines Laufs, mit einer Welle (11), auf der mindestens ein Träger montiert ist, der wenigstens ein in Winkelstellung einstellbares Element trägt, um den Augenblick des Endes eines Laufs festzustellen, und mit einem induktiven Näherungsdetektor (15), der ein Signal beim Passieren des einstellbaren Elements in der Winkelposition in seinem Feststellungsfeld abgeben kann,
dadurch gekennzeichnet, daß der Träger von einer Trommel (10) gebildet wird, die mindestens ein metallisches Segment (13) trägt, welches um ihren Umfang in Winkelstellung einstellbar ist, daß die Trommel (10) auf der Welle (11) montiert ist, welche mit einer Antriebswelle (21) mittels einer Kupplungsplatte (22) gekuppelt ist, welche in der Kupplungsstellung durch einen Blockaderiegel (23) blockiert wird, und daß der induktive Näherungsdetektor (15) in einer Querebene zur Achse der Trommel in der Weise angeordnet ist, daß seine aktive Fläche (16) in vorbestimmter Entfernung vom Umlauf des metallischen Segments (13) während der Drehung der Trommel (10) sich befindet.

2. Vorrichtung nach Anspruch 1, dadurch gekennzeichnet, daß der Blockaderiegel (23) aus einem Arm besteht, der um eine Schwenkachse (24) in der Weise schwenkbar ist, daß er sich in der Querebene zur Welle der Trägertrommel bewegen kann.

3. Vorrichtung nach Anspruch 1 oder 2, dadurch gekennzeichnet, daß ein Anzeigeorgan zum Ansprechen auf ein Signal des induktiven Näherungsdetektors vorgesehen ist.

4. Vorrichtung nach Anspruch 3, dadurch gekennzeichnet, daß das Anzeigeorgan eine Leuchtdiode ist.

## Claims

1. Rotary programmer for travel-limit control, comprising a shaft (11) on which there is mounted at least one support carrying at least one angularly adjustable element for determining the instant when a travel-limit occurs, and an inductive proximity detector (15) that produces a signal when said angularly adjustable element moves within its field of detection, characterised in that the support is comprised of a drum (10) carrying at least one metallic segment (13) that is angularly adjustable in position along its periphery, the drum (10) being mounted on said shaft (11) which is coupled to a driving shaft (21) by means of a clutch plate (22) locked in connecting position by a switch-lock (23), the inductive proximity detector (15) being disposed in a plane extending transversally the drum axis such that its active face (16) is located at a predetermined distance from the travel of the metallic segment (13) during rotation of the drum.

2. Device according to claim 1, characterised in that the switch-lock (23) consists in an arm pivotally jointed to a pivot (24) so as to be able to pivot in a transversal plane in relation to the drum carrying shaft.

3. Device according to claim 1 or 2, characterised by comprising an indicating element for responding to a signal from the inductive proximity detector.

4. Device according to claim 3, characterised in that the indicating element is a luminescent diode.
